# EUROPEAN PATENT SPECIFICATION

(11) **EP 4 411 028 B1**
(45) Date of publication and mention of the grant of the patent: **25.02.2026**
(21) Application number: 22887161.2
(22) Date of filing: 28.10.2022
(51) Int. Cl.: C30B 19/12, C30B 29/16, H01L 21/20, H01L 21/368, C30B 19/02, H01L 21/02

(54) **METHOD FOR PRODUCING BETA-GA2O3/BETA-GA2O3 MULTILAYER BODY**
VERFAHREN ZUR HERSTELLUNG EINES MEHRSCHICHTIGEN BETA-GA2O3/BETA-GA2O3-KÖRPERS
PROCÉDÉ DE PRODUCTION DE CORPS MULTICOUCHE DE BETA-GA2O3/BETA-GA2O3

(30) Priority: 01.11.2021 JP 2021178650
(43) Date of publication of application: 07.08.2024
(73) Proprietor: MITSUBISHI GAS CHEMICAL COMPANY, INC., Chiyoda-ku Tokyo 100-8324 (JP)
(72) Inventor: SEKIWA, Hideyuki, Tokyo 125-8601 (JP); TADOKORO, Hiroaki, Tokyo 125-8601 (JP)
(74) Representative: Gille Hrabal Partnerschaftsgesellschaft mbB Patentanwälte
(86) International application number: PCT/JP2022/040309
(87) International publication number: WO 2023/074836

(56) References cited:
- JP-A- 2010 280 533
- JP-A- 2014 015 366
- JP-A- 2019 182 744
- JP-B2- 5 794 955
- US-A1- 2015 380 500
- HISASHI MURAKAMI ET AL: "Homoepitaxial growth of beta-Ga2O3 layers by halide vapor phase epitaxy", APPLIED PHYSICS EXPRESS, vol. 8, no. 1, 11 December 2014 (2014-12-11), pages 015503, XP055168143, ISSN: 1882-0778, DOI: 10.7567/APEX.8.015503
- ZBIGNIEW GALAZKA: "beta-Ga2O3 for wide-bandgap electronics and optoelectronics", SEMICONDUCTOR SCIENCE TECHNOLOGY, IOP PUBLISHING LTD, GB, vol. 33, no. 11, 10 October 2018 (2018-10-10), pages 113001, XP020331525, ISSN: 0268-1242, [retrieved on 20181010], DOI: 10.1088/1361-6641/AADF78
- MAHADIK NADEEMULLAH A ET AL: "High-resolution dislocation imaging and micro-structural analysis of HVPE-[beta]Ga2O3films using monochromatic synchrotron topography", APL MATERIALS, AMERICAN INSTITUTE OF PHYSICS, 2 HUNTINGTON QUADRANGLE, MELVILLE, NY 11747, vol. 7, no. 2, 14 December 2018 (2018-12-14), XP012233989, [retrieved on 20181214], DOI: 10.1063/1.5051633
- YOKOYAMA, MITSUNORI: "Study of Crystal Growth Methods for Zirconia-, Hafnia-, and Titania-Based Oxides", PH.D. THESIS, HOKKAIDO UNIVERSITY, 25 March 1993 (1993-03-25), pages 8 - 14, XP009545267, DOI: 10.11501/3093008

## Description

### TECHNICAL FIELD

The present invention relates to a method for producing a β-Ga₂O₃/β-Ga₂O₃ multilayer body.

### BACKGROUND ART

Power devices are one of the key devices for improving power usage efficiency to realize a low-carbon society, and are mainly used as elements to configure inverters that convert DC-AC power and adjust AC voltage and frequency. Upon the above-mentioned conversion, energy loss due to the resistance when current flows through the element and generation of wasted current due to the recovery process of charge distribution in the element, which occurs at the moment when the voltage applied to the element is switched, are inevitable. These loss percentages vary with power and frequency, but generally range from a few percent to about a dozen percent. Element structures of conventional Si-based power semiconductors have been devised but further improvement of efficiency is becoming difficult because Si is approaching its physical property limit. Therefore, SiC and GaN are being developed as alternative power device materials to Si. SiC and GaN have band gaps of 3.3 eV and 3.4 eV, respectively, and they are materials having wider band gaps than the band gap of Si (i.e., 1.1 eV). The wider the band gap of a material, the higher the breakdown voltage, which represents the electric field at the boundary where charge is prevented from flowing into the semiconductor (avalanche breakdown), and thus the material can provide a device structure that can withstand higher voltages.

β-Ga₂O₃ is a kind of oxide semiconductor that has been adopted to transparent conductive substrates for GaN-based LEDs, solar-blind UV detectors, etc. Recently, it has attracted attention as a material for power devices and is expected to realize high-voltage and high-efficiency power semiconductors that surpass SiC and GaN. This is due to the fact that the band gap of β-Ga₂O₃ is expected to be 4.5-4.9 eV, which is wider than those of SiC and GaN. Another advantage of β-Ga₂O₃ over SiC and GaN is that it allows growing a crystal from a melt. SiC and GaN have difficulty in growing a crystal from a melt, and have an issue that their substrates are expensive. On the other hand, β-Ga₂O₃ has a melting point at normal pressure, allows bulk crystal growth, and its study and development are progressing through the EFG (Edge-Defined Film-fed Growth) method and the vertical Bridgman method. The former growth method has provided commercially available 2- to 4-inch substrates, and the latter is used for the development of 4-inch substrates.

In order to apply β-Ga₂O₃ to power devices, a β-Ga₂O₃ (epitaxial layer)/β-Ga₂O₃ (substrate) multilayer body consisting of two layers of β-Ga₂O₃ with different residual electron densities is required. The thickness of the epitaxial layer needs to be around several µm to 20 µm, and vapor-phase growth methods such as metal organic chemical vapor deposition (MOCVD), molecular beam epitaxy (MBE), mist CVD, and halide vapor-phase epitaxy (HVPE) have traditionally been used. However, the vapor-phase growth method is a non-thermodynamic growth method and has the disadvantages of poor crystal quality and slow growth rate.

For example, Non-patent literature 1 discloses a method of epitaxial growth of β-Ga₂O₃ on a sapphire substrate by the HVPE method. According to this method, the sapphire substrate and β-Ga₂O₃ have different crystal structures, resulting in multiple rotational domains and an epitaxial layer that is not composed of a single domain. This layer is not strictly a single crystal and cannot be used for power devices. The full width at half maximum of the X-ray rocking curve of the epitaxial layer obtained by the same method is as high as 0.5 deg (1,800 arcsec), indicating low crystallinity. Patent literature 1 also discloses a method of epitaxial growth of B-Ga₂O₃ on a β-Ga₂O₃ substrate by the HVPE method to obtain a β-Ga₂O₃/β-Ga₂O₃ multilayer body (hereinafter simply referred to as a "β-Ga₂O₃ multilayer body"). Although a β-Ga₂O₃/β-Ga₂O₃ multilayer body can be obtained by this method, the growth rate of the epitaxial layer is as low as 2.7-6.0 µm/hr.

On the other hand, the liquid-phase growth method has the advantage of producing a high-quality crystal more easily than the vapor-phase growth method because crystal growth proceeds in principle in thermal equilibrium. The melting point of β-Ga₂O₃ is as high as 1970°C, and it is difficult to maintain a stable melt surface near the melting point, making it difficult to grow β-Ga₂O₃ by the Czochralski method, which is employed for single-crystal silicon and the like. Therefore, a single crystal is grown by the above-mentioned EFG method or vertical Bridgman method. However, a β-Ga₂O₃ multilayer body cannot be obtained by the EFG or the vertical Bridgman method. Examples of a method in which a target substance is dissolved in a suitable solvent, the temperature of the mixed solution is lowered to a supersaturated state, and the target substance is grown from the melt include the static slow-cooling method, the flux method, the floating zone method, the top seeded solution growth (TSSG) method, the solution pulling method, and the liquid-phase epitaxy (LPE) method.

Patent literature 2 discloses a method for obtaining a β-Ga₂O₃ epitaxial layer by the LPE method. According to this method, a β-Ga₂O₃ single-crystal layer is stacked on a sapphire substrate by the LPE method, and a β-Ga₂O₃ multilayer body cannot be obtained because the substrate is made of sapphire. Moreover, the crystal structure of the sapphire substrate is corundum, while the crystal structure of β-Ga₂O₃ is monoclinic, and so they have different crystal structures. In addition, there is a problem of poor crystal quality due to inconsistent lattice constants.

When a β-Ga₂O₃ single-crystal layer is grown by the liquid-phase growth method such as the LPE method, a solvent capable of dissolving β-Ga₂O₃ is required. In Patent literature 2, PbO and PbF₂ are exemplified as solvents, and either one of them is used. In order to establish a stable and well reproducible single-crystal growth method, it is common practice to keep the melt at a temperature about 100-200°C above its melting point so that the solvent and solute are mixed homogeneously. In Patent literature 2, the melt is maintained at 1100°C. The melting points of PbO and PbF₂ are about 886°C and 824°C, respectively. In general, when the temperature of the melt containing either PbO or PbF₂ exceeds 1000°C, some of PbO or PbF₂ volatilizes and the composition of the melt changes, which is not favorable for growing a β-Ga₂O₃ single crystal in a stable and well reproducible manner. In addition, since the vaporized PbO or PbF₂ reacts with the furnace material constituting the crystal growing furnace, the number of times the furnace material can be used is reduced and toxic Pb is volatilized, which increase the cost because the crystal growing furnace needs to have a closed structure or the like.

As described above, as a method for obtaining a β-Ga₂O₃ multilayer body that is useful for power devices, methods employing vapor-phase growth of β-Ga₂O₃ on a β-Ga₂O₃ substrate have the disadvantages of poor crystal quality and slow growth rate. Alternatively, when a liquid-phase growth method is used, which in principle is close to thermal equilibrium growth and which is expected to result in high crystallinity and high growth rate, there is a problem where a β-Ga₂O₃ multilayer body cannot be obtained by a conventional method. In addition, use of either PbO or PbF₂ as a solvent and the high vapor pressure of the conventional liquid-phase growth method make it difficult to grow a β-Ga₂O₃ single crystal in a stable and cost-effective manner.

Patent literature 3 relates to a Ga₂O₃-based single crystal substrate.

Non-patent literature 2 relates to homoepitaxial growth of β- Ga₂O₃ layers by halide vapor phase epitaxy.

Non-patent literature 3 relates to β-Ga₂O₃ for wide-bandgap electronics and optoelectronics.

Non-patent literature 4 relates to a high-resolution dislocation imaging and micro-structural analysis of HVPE-OGa₂O₃ films using monochromatic synchrotron topography.

### CITATION LIST

### Patent literature

Patent literature 1: Japanese Patent No. 6744523
Patent literature 2: Japanese Patent No. 5794955 (JP 2014 015366 A)
Patent literature 3: US 2015/380500 A1

### Non-patent literature

Non-patent literature 1: Journal of the Japanese Association for Crystal Growth, Vol. 42, No. 2, (2015), pp. 141-147
Non-patent literature 2: Applied Physics Express, vol. 8, no. 1, page 015503
Non-patent literature 3: Semiconductor Science and Technology, vol. 33, no. 11, page 113001.
Non-patent literature 4: APL Materials, vol. 7, no. 2, page 0022513.

### SUMMARY OF INVENTION

### Technical Problem

The present invention has an objective of solving at least one of the above-described conventional problems. Further, the present invention has an objective of providing a method for producing a β-Ga₂O₃/β-Ga₂O₃ multilayer body by stacking a β-Ga₂O₃ single crystal having high crystallinity and fast growth rate on a β-Ga₂O3 substrate by a liquid-phase epitaxial growth method.

Herein, a β-Ga₂O₃/β-Ga₂O₃ multilayer body refers to a multilayer body in which an epitaxial layer containing β-Ga₂O₃ is stacked on a substrate containing β-Ga₂O₃.

### Solution to Problem

The present inventors have diligently studied to solve the above problems and found that the above problems can be solved by the invention defined in the independent claims.

### Advantageous Effects of Invention

According to a preferred embodiment of the present invention, evaporation of the solvent is suppressed, and stable crystal growth with minimal composition fluctuation can be achieved. Moreover, the consumption of furnace materials is reduced, and it is not necessary for the growth furnace to be a closed system, thereby enabling manufacturing at a lower cost. In addition, since the liquid-phase growth method is used as the crystal growth method, a β-Ga₂O₃ single-crystal layer can be grown with high crystallinity at a high growth rate. The β-Ga₂O₃ multilayer body produced by this embodiment can be used for power devices using β-Ga₂O₃ multilayer bodies that are expected to be developed in the future.

### BRIEF DESCRIPTION OF DRAWINGS

[Figure 1] Figure 1 shows a phase diagram of PbO-Bi₂O₃.
[Figure 2] Figure 2 shows a phase diagram of PbO-PbF₂.
[Figure 3] Figure 3 shows a schematic diagram of one typical LPE growing furnace.
[Figure 4] Figure 4 shows a X-ray rocking curve of the (002) plane of the epitaxial layer of the multilayer body obtained in Example 1.

### DESCRIPTION OF EMBODIMENTS

A first embodiment of the present invention is a method for producing a β-Ga₂O₃/O-Ga₂O₃ multilayer body, the method comprising mixing and melting Ga₂O₃ as a solute and PbO and Bi₂O₃ as solvents, then bringing a β-Ga₂O₃ substrate into direct contact with the resulting melt, and allowing a β-Ga₂O₃ single crystal to grow on the β-Ga₂O₃ substrate by a liquid-phase epitaxial growth method, thereby obtaining the β-Ga₂O₃/β-Ga₂O₃ multilayer body.

Hereinafter, the principle of the first embodiment of the present invention will be described.

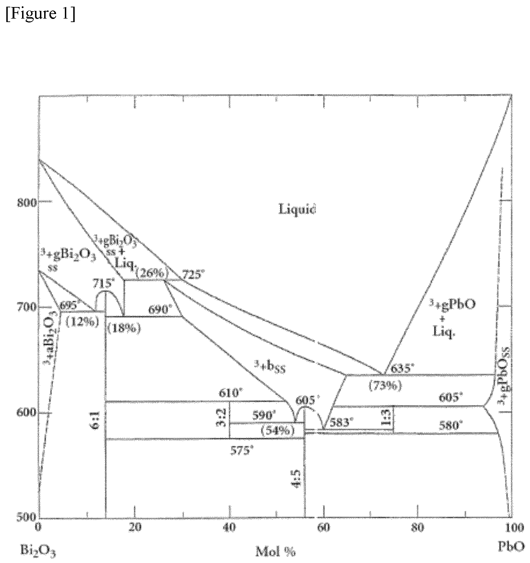

Figure 1 shows a phase diagram of PbO-Bi₂O₃ (Source: Temperature/combination phase diagram of the system Bi₂O₃-PbO, J. Am. Chem. Soc., 64[3], 182-184, 1981). PbO and Bi₂O₃ form a eutectic system, and they can be mixed to lower the melting point. By mixing PbO and Bi₂O₃ to give the PbO concentration in the range of 0.1-95 mol%, the melting point of the PbO + Bi₂O₃ mixture can be reduced to be lower than or equal to the melting point of PbO alone or Bi₂O₃ alone. This indicates that the amount of vaporization of PbO or Bi₂O₃ in the above PbO concentration range can be suppressed compared to that of PbO or Bi₂O₃ alone.

The solvent composition is preferably PbO: Bi₂O₃ = 0.1-95 mol%: 99.9-5 mol%. More preferably, the solvent composition is PbO: Bi₂O₃ = 20-90 mol%: 80-10 mol%, and particularly preferably PbO: Bi₂O₃ = 50-80 mol%: 50-20 mol%. Since the LPE growth temperature (temperature at the time of epitaxial growth) is higher when PbO or Bi₂O₃ alone is used as the solvent, a mixed solvent such as the one mentioned above is favorable.

The mixing ratio of Ga₂O₃ as the solute and PbO and Bi₂O₃ as the solvents is preferably solute: solvents = 5-30 mol%: 95-70 mol%. More preferably, the solute concentration is 14 mol% or more but 27 mol% or less. Solute concentrations lower than 5 mol% may result in a slow crystal growth rate while solute concentrations higher than 30 mol% may result in a high LPE growth temperature and increased solvent volatilization. It may also result in a faster crystal growth rate and poor crystal quality.

In the first embodiment of the present invention, the growth rate of the layer containing a β-Ga₂O₃ single crystal (epitaxial layer) formed by the liquid-phase epitaxial growth method is preferably 10-50 µm/hr, and more preferably 20-30 µm/hr. Growth rates lower than 10 µm/hr may result in a slow growth rate and increased cost. In addition, growth rates higher than 50 µm may result in poor crystal quality. Here, the growth rate can be obtained from the difference in film thickness before and after LPE growth and the growth time.

Next, a second embodiment of the present invention is a method for producing a β-Ga₂O₃/β-Ga₂O₃ multilayer body, the method comprising mixing and melting Ga₂O₃ as a solute and PbO and PbF₂ as solvents, then bringing a β-Ga₂O₃ substrate into direct contact with the resulting melt, and allowing a β-Ga₂O₃ single crystal to grow on the β-Ga₂O₃ substrate by a liquid-phase epitaxial growth method, thereby obtaining the β-Ga₂O₃/β-Ga₂O₃ multilayer body.

The principle of the second embodiment of the present invention will be described.

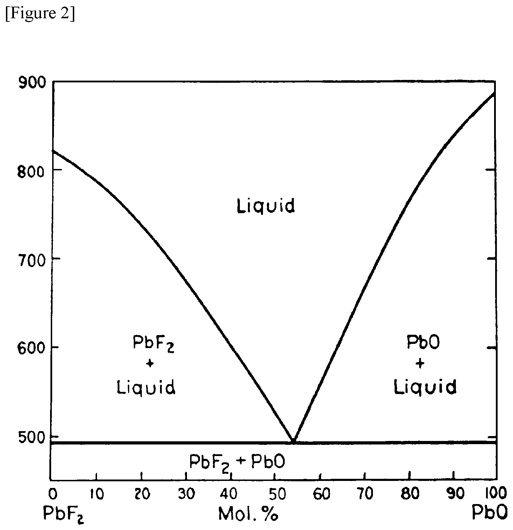

Figure 2 shows a phase diagram of PbO-PbF₂ (Source: C. Sandonnini Atti, Accad. Naz. Licei, C1. Sci. Fis. Mat. Nat., 23[Ser.5, Pt.1], 962-964 (1914)). PbO and PbF₂ form a eutectic system, and they can be mixed to lower the melting point. By mixing PbO with PbF₂ to give the PbF₂ concentration in the range of about 0.01-86 mol%, the melting point of the PbO + PbF₂ mixture can be reduced to be lower than or equal to the melting point of PbO alone or PbF₂ alone. This indicates that the amount of vaporization of PbO or PbF₂ in the above PbO + PbF₂ concentration range can be suppressed compared to that of PbO or PbF₂ alone.

The solvent composition is preferably PbO: PbF₂ = 2-80 mol%: 98-20 mol%. More preferably, the solvent composition is PbO: PbF₂ = 20-80 mol%: 80-20 mol%, and particularly preferably PbO: PbF₂ = 40-60 mol%: 60-40 mol%. Since the LPE growth temperature is higher when PbO or PbF₂ alone is used as the solvent, a mixed solvent such as the one mentioned above is favorable.

The mixing ratio of Ga₂O₃ as the solute and PbO and PbF₂ as the solvents is preferably solute: solvents = 2-20 mol%: 98-80 mol%. More preferably, the solute concentration is 10 mol% or more but 20 mol% or less. Solute concentrations lower than 2 mol% may result in a slow growth rate while solute concentrations higher than 20 mol% may result in a high LPE growth temperature and increased solvent volatilization. It may also result in a faster crystal growth rate and poor crystal quality.

In the second embodiment of the present invention, the growth rate of the layer containing a β-Ga₂O₃ single crystal (epitaxial layer) formed by the liquid-phase epitaxial growth method is preferably 10-50 µm/hr, and more preferably 20-30 µm/hr. Growth rates lower than 10 µm/hr may result in a slow growth rate and increased cost. In addition, growth rates higher than 50 µm may result in poor crystal quality. Here, the growth rate can be obtained from the difference in film thickness before and after LPE growth and the growth time.

In the first and second embodiments of the present invention, for the purposes of controlling the LPE growth temperature, adjusting the solvent viscosity, and doping foreign elements, one or more third components can be added to the solvent to the extent that the solubility of Ga₂O₃ and the amount of PbO + Bi₂O₃ or PbO + PbF₂ vaporization are not significantly changed. Examples of the third component include B₂O₃, V₂O₅, P₂O₅, MoO₃, and WO₃. Bi₂O₃ may also be added as a third component to the solvent of the second embodiment.

The most preferred growth method for a β-Ga₂O₃ multilayer body according to the present invention is a liquid-phase epitaxial growth method using a β-Ga₂O₃ substrate.

In a β-Ga₂O₃ multilayer body useful as a power device, the residual electron density in the epitaxial layer needs to be controlled. Ga in β-Ga₂O₃ is a trivalent oxide and generally exhibits n-type conductivity. In the first and second embodiments of the present invention, the residual electron density, band gap, insulating property, etc. can be imparted by doping a foreign element into β-Ga₂O₃. For example, doping divalent impurities MgO or ZnO into β-Ga₂O₃ can reduce the residual electrons. On the other hand, the residual electron density can be increased by doping tetravalent impurities SiO₂ or SnO₂. In addition, Fe₂O₃ doping can provide an insulating property. Meanwhile, the band gap can be increased by doping MgO or Al₂O₃, which has a wider band gap than β-Ga₂O₃, to obtain a mixed crystal. On the other hand, the band gap can be reduced by doping ZnO or CdO to obtain a mixed crystal.

A layer containing the β-Ga₂O₃ single crystal formed by the liquid-phase epitaxial growth method contains, one or more foreign elements selected from the group consisting of Be, Mg, Ca, Sr, Ba, Ti, Zr, Hf, Fe, Co, Ni, Cu, Zn, Cd, Al, In, Si, Ge, Sn, and Pb, preferably in the range of 0.01-20 mol%, more preferably in the range of 0.1-10 mol%. Doping amounts of foreign elements less than 0.01 mol% may result in poor properties, and doping amounts greater than 20 mol% may cause difficulties in crystal growth.

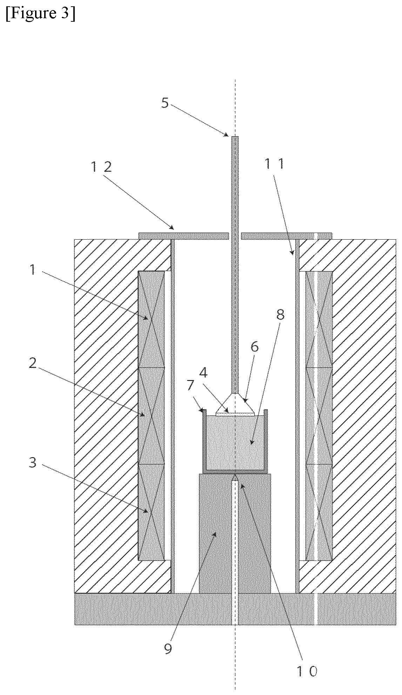

Figure 3 shows a schematic diagram of a typical LPE growing furnace. Inside the LPE growing furnace, a platinum crucible 7, in which raw materials are melted and stored as a melt 8, is placed on a crucible stand 9 made of mullite (a compound of aluminum oxide and silicon dioxide). Three-stage side heaters (upper heater 1, middle heater 2, and lower heater 3) that heat and melt the raw materials in the platinum crucible 7 are provided outside and to the side of the platinum crucible 7. The heater outputs are independently controlled, and the amount of heat applied to the melt 8 is independently adjusted. A mullite furnace core tube 11 is placed between the heaters and the inner wall of the production furnace, and a mullite furnace lid 12 is placed above the furnace core tube 11. A pull-up mechanism is provided above the platinum crucible 7. An alumina growing shaft 5 is secured to the pull-up mechanism, and a substrate holder 6 and a substrate 4 secured by the holder are provided at one end of the shaft. A mechanism for rotating the shaft is provided at the top of the growing shaft 5. In addition, a thermocouple 10 is provided at the bottom of the crucible.

A third embodiment not being claimed is a β-Ga₂O₃/β-Ga₂O₃ multilayer body having a layer containing a β-Ga₂O₃ single crystal on a β-Ga₂O₃ substrate, wherein the full width at half maximum of the rocking curve of the layer containing the β-Ga₂O₃ single crystal is 5-100 arcsec.

The above-described β-Ga₂O₃/β-Ga₂O₃ multilayer body can favorably be produced by the first and second embodiments of the present invention described above.

The full width at half maximum of the rocking curve of the layer containing the β-Ga₂O₃ single crystal is 5-100 arcsec, preferably 5-80 arcsec, and more preferably 5-50 arcsec. The full width at half maximum above 100 arcsec may result in low crystallinity and performance of the power device may be degraded. The β-Ga₂O₃/β-Ga₂O₃ multilayer body is characterized by its high crystallinity. The method described in the examples described below can be adopted as the method for measuring a full width at half maximum of a rocking curve.

### EXAMPLES

Hereinafter, a method of depositing a β-Ga₂O₃ epitaxial layer on a β-Ga₂O₃ substrate will be described as a method for growing a β-Ga₂O₃/β-Ga₂O₃ multilayer body according to one embodiment of the present invention. The present invention should not be limited in any way to the following examples.

Hereinafter, an exemplary production method of the present invention will be described with reference to Figure 3.

A platinum crucible 7, in which raw materials are melted and stored as a melt 8, is placed on a crucible stand 9. Three-stage side heaters (upper heater 1, middle heater 2, and lower heater 3) that heat and melt the raw materials in the platinum crucible 7 are provided outside and to the side of the platinum crucible 7. The heater outputs are independently controlled, and the amount of heat applied to the melt 8 is independently adjusted. A furnace core tube 11 is placed between the heaters and the inner wall of the production furnace, and a furnace lid 12 is placed above the furnace core tube 11. A pull-up mechanism is provided above the platinum crucible 7. An alumina growing shaft 5 is secured to the pull-up mechanism, and a substrate holder 6 and a substrate 4 (β-Ga₂O₃ substrate) secured by the holder are provided at one end of the shaft. A mechanism for rotating the shaft is provided at the top of the growing shaft 5. In addition, a thermocouple 10 is provided at the bottom of the crucible.

In order to melt the raw materials in the platinum crucible 7, the production furnace is heated until the raw materials are melted. Preferably, the temperature is raised to 600-1000°C, more preferably to 700-900°C, and the raw material melt is allowed to stand for 2-3 hours to homogenize. Instead of leaving it stationary, a platinum plate attached to one end of the alumina shaft can be immersed in the melt to stir and homogenize the melt by rotating the shaft. It is desirable to allow a β-Ga₂O₃ single-crystal layer to grow only directly below the substrate. If the growth of the β-Ga₂O₃ single crystal occurs in the melt where it is not directly below the substrate, the grown single crystal will adhere to the substrate by convection currents in the melt, resulting in phases with different growth orientations, which is undesirable. Therefore, a temperature gradient is applied to the three-stage heaters so that the temperature of the crucible bottom is a few degrees higher than that of the melt surface. After the temperature of the melt has stabilized, a seed crystal substrate is brought into contact with the melt surface. After the seed crystal substrate comes into uniform contact with the melt, the temperature is kept constant, or the temperature is lowered at a rate of 0.025-5°C/hr, to allow a β-Ga₂O₃ single-crystal layer of interest to grow on the surface of the seed crystal substrate. During the growth, the seed crystal substrate is rotated at 5-300 rpm by the rotation of the growing shaft, and the rotation direction is reversed at regular intervals. After allowing a crystal to grow for about 30 minutes to 24 hours, the growing shaft is lifted to separate the grown crystal from the melt, and the melt attached to the surface of the grown crystal is removed by rotating the growing shaft at 50 to 300 rpm. The temperature is then allowed to cool to room temperature over a period of 1-24 hours to obtain the desired β-Ga₂O₃/β-Ga₂O₃ multilayer body.

### (Example 1)

A platinum crucible 7 with inner diameter of 120 mm, height of 150 mm, and thickness of 1 mm was filled with 2661.2 g of PbO (purity: 99.999%), 2777.7 g of Bi₂O₃ (purity: 99.999%), and 561.2 g of Ga₂O₃ (purity: 99.999%) as raw materials. The mixing ratio of Ga₂O₃ as the solute to PbO and Bi₂O₃ as the solvents was solute: solvents = 14.3 mol%: 85.7 mol%, and the mixing ratio of the solvents, PbO and Bi₂O₃, was PbO: Bi₂O₃ = 67 mol%: 33 mol%. The platinum crucible 7 fed with the raw materials was placed in a LPE furnace shown in Figure 3, and the temperature at the bottom of the crucible was set at about 850°C to melt the raw materials. After stirring the melt using a platinum plate for 6 hours, the temperature was lowered until the temperature at the bottom of the crucible reached 750 °C, and a 11 mm x 11 mm x 650 µm thick, C-plane oriented β-Ga₂O₃ substrate grown by the EFG method was brought into contact with it. Growth was allowed to continue for 3 hours at the same temperature while rotating the growing shaft 5 made of alumina at 60 rpm. The rotation direction was reversed every 5 minutes. Thereafter, the substrate was separated from the melt by pulling up the growing shaft 5 and the melt components were removed by rotating the growing shaft 5 at 200 rpm. The temperature was then allowed to cool to room temperature to obtain a β-Ga₂O₃/β-Ga₂O₃ multilayer body. Melt components that could not be removed completely were removed using hydrochloric acid. The average thickness of the epitaxial layer was about 90 µm. The average growth rate was about 30 µm/hr.

### (Comparative examples 1-2)

Attempts were made to produce β-Ga₂O₃/β-Ga₂O₃ multilayer bodies in the same manner as in Example 1 except that the composition of the feed was changed to give the composition shown in Table 1 below, and the temperature at which the raw materials were melted, and the growth temperature were changed as shown in Table 1.

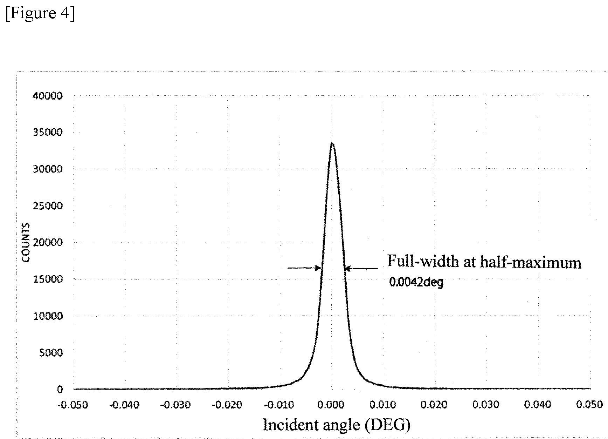

Here, the crystallinity of the epitaxial layer of the β-Ga₂O₃/β-Ga₂O₃ multilayer body obtained in Example 1 was evaluated by the full width at half maximum of the rocking curve of the (002) plane. The result is shown in Figure 4. The full width at half maximum of the rocking curve of the (002) plane was 0.0042 deg (= 15 arcsec). The full width at half maximum of the rocking curve was measured using an X-ray diffractometer (X'pert MRD from Spectris plc). Using the same apparatus, 2θ, ω, χ, and φ were adjusted for axis alignment that allows detection of the peak of the (002) plane of β-Ga₂O₃, and then the measurement was performed with a tube voltage of 45 KV and a tube current of 40 mA. The incident light was monochromatized using Ge(220) planes of four crystals. Other measurement conditions were as follows.
Light source; Cu-Kα
Wavelength; 0.15418 nm
Measurement mode; ω-scan (incident angle scan)
ω range; Angle at which the β-Ga₂O₃ (002) plane appears was set for each sample
ω range; 0.1 deg
ω step; 0.0005 deg
2θ position; Angle at which the β-Ga₂O₃ (002) plane appears was set for each sample
Collimator diameter; 0.5 mm
Anti-scattering slit; 1.5 mm

### (Examples 2-8)

β-Ga₂O₃/β-Ga₂O₃ multilayer bodies were obtained in the same manner as in Example 1 except that the composition of the feed was changed to give the composition shown in Table 1 below, and the temperature at which the raw materials were melted and the growth temperature were changed as shown in Table 1. The epitaxial layer obtained in Example 2 was a mixed layer of β-Ga₂O₃ and MgO, and the epitaxial layer obtained in Example 5 was a mixed layer of β-Ga₂O₃ and Al₂O₃.

### [Table 1]

**Table 1**

| | Components in solvent | | Amount of solute Ga₂O₃ (mol%) | Amount of foreign element MgO ( mol%) | Amount of foreign element Al₂O₃ (mol%) | Amount of solvent (mol%) | Temperature at which raw materials were melted (°C) | LPE growth temperature (°C) | Growth rate (µm/hr) | Full width at half maximum of rocking curve (arcsec) |
|---|---|---|---|---|---|---|---|---|---|---|
| | PbO (mol%) | Bi₂O₃ (mol%) | | | | | | | | |
| Example 1 | 67 | 33 | 14.3 | 0 | 0 | 85.7 | 850 | 750 | 30 | 15 |
| Example 2 | 67 | 33 | 11.4 | 2.9 | 0 | 85.7 | 840 | 740 | 25 | 23 |
| Example 3 | 67 | 33 | 19.8 | 0 | 0 | 80.2 | 980 | 818 | 13 | 15 |
| Example 4 | 67 | 33 | 21 | 0 | 0 | 79 | 980 | 850 | 13 | 16 |
| Example 5 | 67 | 33 | 14.3 | 0 | 2.9 | 82.8 | 980 | 760 | 25 | 28 |
| Example 6 | 80 | 20 | 19.8 | 0 | 0 | 80.2 | 980 | 780 | 15 | - |
| Example 7 | 80 | 20 | 25 | 0 | 0 | 75 | 980 | 910 | 15 | 25 |
| Example 8 | 33 | 67 | 19.8 | 0 | 0 | 80.2 | 980 | 850 | 15 | - |
| Comparative example 1 | 100 | 0 | 14.3 | 0 | 0 | 85.7 | 1,090 | 990 | - | - |
| Comparative example 2 | 0 | 100 | 14.3 | 0 | 0 | 85.7 | 1,030 | 930 | - | - |

As described above, a β-Ga₂O₃/β-Ga₂O₃ multilayer body can be produced by mixing and melting Ga₂O₃ as a solute and PbO and Bi₂O₃ as solvents, then bringing a β-Ga₂O₃ substrate into direct contact with the resulting melt. As can be appreciated by comparing Examples 1-8 with Comparative examples 1-2, the melting point of the solvent can be lowered by mixing PbO and Bi₂O₃ compared to PbO or Bi₂O₃ alone. Therefore, both the temperature at which the raw materials were melted and the growth temperature of β-Ga₂O₃ were lower than those in the case of using a single solvent. This means that the amount of vaporization of the solvent components can be reduced. According to this method, since evaporation of the solvent is suppressed, stable crystal growth with minimal composition fluctuation can be achieved. Moreover, the consumption of furnace materials is reduced, and it is not necessary for the growth furnace to be a closed system, thereby enabling manufacturing at a lower cost. In addition, as mentioned above, the present invention is a liquid-phase growth method that is close to thermal equilibrium growth. Therefore, as shown in Table 1 above, the growth rate was as fast as 13-30 µm/hr, and the full width at half maximum of the rocking curve was as narrow as 15-28 arcsec, showing high crystallinity. On the other hand, in Comparative examples 1-2, multilayer bodies were not produced because the raw materials did not melt unless the heat applied was higher than 1000°C and the solvent volatilized at a temperature higher than 1000°C.

### (Example 9)

A platinum crucible 7 with an inner diameter of 120 mm, a height of 150 mm, and a thickness of 1 mm was filled with 1022.3 g of PbO (purity: 99.999%), 4503.7 g of PbF₂ (99%), and 476.2 g of β-Ga₂O₃ as raw materials. The mixing ratio of Ga₂O₃ as the solute to PbO and PbF₂ as the solvents was solute: solvents = 10.0 mol%: 90 mol%, and the mixing ratio of the solvents, PbO and PbF₂, was PbO: PbF₂ = 20 mol%: 80 mol%. The platinum crucible 7 fed with the raw materials was placed in a LPE furnace shown in Figure 3, and the temperature at the bottom of the crucible was set at about 940°C to melt the raw materials. After stirring the melt using a platinum plate for 6 hours, the temperature was lowered until the temperature at the bottom of the crucible reached 840 °C, and a 11 mm x 11 mm x 650 µm thick, C-plane oriented B-Ga₂O₃ substrate grown by the EFG method was brought into contact with it. Growth was allowed to continue for 3 hours at the same temperature while rotating a growing shaft 5 made of alumina at 60 rpm. The shaft rotation was reversed every 5 minutes. Thereafter, the substrate was separated from the melt by pulling up the growing shaft 5 and the melt components were removed by rotating the growing shaft 5 at 200 rpm. The temperature was then allowed to cool to room temperature to obtain a β-Ga₂O₃/β-Ga₂O₃ multilayer body. Melt components that could not be removed completely were removed using nitric acid. The average thickness of the epitaxial layer was about 69 µm. The average growth rate was about 23 µm/hr.

### (Examples 10-11, Comparative example 3)

β-Ga₂O₃/β-Ga₂O₃ multilayer bodies were obtained in the same manner as in Example 9 except that the composition of the feed was changed to give the composition shown in Table 2 below, and the temperature at which the raw materials were melted and the growth temperature were changed as shown in Table 2.

### [Table 2]

**Table 2**

| | Components in solvent | | Amount of solute Ga₂O₃ (mol%) | Amount of solvent (mol%) | Temperature at which raw materials were melted (°C) | LPE growth temperature (°C) | Growth rate ( µm/hr) | Full width at half maximum of rocking curve (arcsec) |
|---|---|---|---|---|---|---|---|---|
| | PbO (mol%) | PbF₂ (mol%) | | | | | | |
| Example 9 | 20 | 80 | 10 | 90 | 940 | 840 | 23 | 39 |
| Example 10 | 54 | 46 | 10 | 90 | 700 | 600 | 25 | 35 |
| Example 11 | 80 | 20 | 10 | 90 | 950 | 850 | 18 | 43 |
| Comparative example 3 | 0 | 100 | 10 | 90 | 1,030 | 930 | - | - |

### (Examples 12-13)

β-Ga₂O₃/β-Ga₂O₃ multilayer bodies were obtained in the same manner as in Example 9 except that the composition of the feed was changed to give the composition shown in Table 3 below, and the temperature at which the raw materials were melted and the growth temperature were changed as shown in Table 3. If the concentration of Ga₂O₃ as the solute is lower than 2 mol%, the melting point becomes closer to the melting point of the solvent, and stable crystal growth may be difficult due to the viscosity of the solvent. Moreover, a solute concentration higher than 20 mol% may result in a high growth temperature. Therefore, the concentration of Ga₂O₃ as the solute is preferably 2-20 mol%.

### [Table 3]

**Table 3**

| | Components in solvent | | Amount of solute Ga₂O₃ (mol%) | Amount of solvent (mol%) | Temperature at which raw materials were melted (°C) | LPE growth temperature (°C) | Growth rate ( µm/hr) | Full width at half maximum of rocking curve (arcsec) |
|---|---|---|---|---|---|---|---|---|
| | PbO (mol%) | PbF₂ (mol%) | | | | | | |
| Example 12 | 54 | 46 | 2 | 98 | 680 | 580 | 20 | 77 |
| Example 13 | 54 | 46 | 20 | 80 | 930 | 830 | 29 | 76 |

As described above, a β-Ga₂O₃/β-Ga₂O₃ multilayer body can be produced by mixing and melting Ga₂O₃ as a solute and PbO and PbF₂ as solvents, then bringing a β-Ga₂O₃ substrate into direct contact with the resulting melt. As can be appreciated by comparing Examples 9-13 with Comparative examples 1 and 3, the melting point of the solvent can be lowered by mixing PbO and PbF₂ compared to PbO or PbF₂ alone. Therefore, both the temperature at which the raw materials were melted and the growth temperature of β-Ga₂O₃ were lower than those in the case of using a single solvent. This means that the amount of vaporization of the solvent components can be reduced. According to this method, since the amount of evaporation of the solvent is suppressed, stable crystal growth with minimal composition fluctuation can be achieved. Moreover, the consumption of furnace materials is reduced, and it is not necessary for the growth furnace to be a closed system, thereby enabling manufacturing at a lower cost. In addition, as mentioned above, the present invention is a liquid-phase growth method that is close to thermal equilibrium growth. Therefore, as shown in Tables 2 and 3 above, the growth rate was as fast as 18-29 µm/hr, and the full width at half maximum of the rocking curve was as narrow as 35-77 arcsec, showing high crystallinity. On the other hand, in Comparative example 3, a multilayer body was not produced because the raw materials did not melt unless the heat applied was higher than 1000°C and the solvent volatilized at a temperature higher than 1000°C.

As described above, in each of Examples 1-13, the full width at half maximum of the rocking curve of the (002) plane of the β-Ga₂O₃ epitaxial layer obtained by the LPE method was 15-77 arcsec, showing extremely high crystalline.

### REFERENCE SIGNS LIST

1 Upper heater
2 Middle heater
3 Lower heater
4 Substrate
5 Growing shaft (made of alumina)
6 Substrate holder
7 Platinum crucible
8 Melt in crucible
9 Crucible stand (made of mullite)
10 Thermocouple at the bottom of crucible
11 Furnace core tube (made of mullite)
12 Furnace lid (made of mullite)

## Claims

1. A method for producing a β-Ga₂O₃/β-Ga₂O₃ multilayer body, the method comprising mixing and melting Ga₂O₃ as a solute and PbO and Bi₂O₃ as solvents, then bringing a β-Ga₂O₃ substrate into direct contact with the resulting melt, and allowing a β-Ga₂O₃ single crystal to grow on the B-Ga₂O₃ substrate by a liquid-phase epitaxial growth method, thereby obtaining the β-Ga₂O₃/β-Ga₂O₃ multilayer body in which an epitaxial layer containing β-Ga₂O₃ is stacked on the β-Ga₂O₃ substrate.

2. The method for producing a β-Ga₂O₃/β-Ga₂O₃ multilayer body according to claim 1, wherein a mixing ratio of Ga₂O₃ as the solute and PbO and Bi₂O₃ as the solvents is solute: solvents = 5-30 mol%: 95-70 mol%, and a mixing ratio of the solvents, PbO and Bi₂O₃, is PbO: Bi₂O₃ = 0.1-95 mol%: 99.9-5 mol%.

3. A method for producing a β-Ga₂O₃/β-Ga₂O₃ multilayer body, the method comprising mixing and melting Ga₂O₃ as a solute and PbO and PbF₂ as solvents, then bringing a β-Ga₂O₃ substrate into direct contact with the resulting melt, and allowing a β-Ga₂O₃ single crystal to grow on the B-Ga₂O₃ substrate by a liquid-phase epitaxial growth method, thereby obtaining the β-Ga₂O₃/β-Ga₂O₃ multilayer body in which an epitaxial layer containing β-Ga₂O₃ is stacked on the β-Ga₂O₃ substrate.

4. The method for producing a β-Ga₂O₃/β-Ga₂O₃ multilayer body according to claim 3, wherein a mixing ratio of Ga₂O₃ as the solute and PbO and PbF₂ as the solvents is solute: solvents = 2-20 mol%: 98-80 mol%, and a mixing ratio of the solvents, PbO and PbF₂, is PbO: PbF₂ = 2-80 mol%: 98-20 mol%.

5. The method for producing a β-Ga₂O₃/β-Ga₂O₃ multilayer body according to any one of claims 1 to 4, wherein the layer containing the β-Ga₂O₃ single crystal formed by the liquid-phase epitaxial growth method comprises foreign elements in an amount of 0.01 mol% or more but 20 mol% or less.

6. The method for producing a β-Ga₂O₃/β-Ga₂O₃ multilayer body according to claim 5, wherein the foreign element is one or more selected from the group consisting of Be, Mg, Ca, Sr, Ba, Ti, Zr, Hf, Fe, Co, Ni, Cu, Zn, Cd, Al, In, Si, Ge, Sn, and Pb.

## Patentansprüche

1. Verfahren zur Herstellung eines β-Ga₂O₃ / β-Ga₂O₃-Mehrschichtkörpers, wobei das Verfahren das Mischen und Schmelzen von Ga₂O₃ als gelösten Stoff und PbO und Bi₂O₃ als Lösungsmittel, dann das direkte Inkontaktbringen eines β-Ga₂O₃-Substrats mit der resultierenden Schmelze umfasst, um ein β-Ga₂O₃-Einkristall auf dem β-Ga₂O₃-Substrat durch ein Flüssigphasen-Epitaxieverfahren wachsen zu lassen, wodurch der β-Ga₂O₃ / β-Ga₂O₃-Mehrschichtkörper erhalten wird, in dem eine β-Ga₂O₃ enthaltende Epitaxieschicht auf dem β-Ga₂O₃-Substrat aufgebracht ist.

2. Verfahren zur Herstellung eines β-Ga₂O₃ / β-Ga₂O₃-Mehrschichtkörpers gemäß Anspruch 1, wobei ein Mischungsverhältnis von Ga₂O₃ als gelöster Stoff und PbO und Bi₂ O₃ als Lösungsmittel ein Mischungsverhältnis von Lösungsmittel: Lösungsmittel = 5-30 Mol-% : 95-70 Mol-% aufweist und ein Mischungsverhältnis der Lösungsmittel PbO und Bi₂ O₃ von PbO : Bi₂ O₃ = 0,1-95 Mol-%:99,9-5 Mol-% vorliegt.

3. Verfahren zur Herstellung eines β-Ga₂O₃ / β-Ga₂O₃-Mehrschichtkörpers, wobei das Verfahren das Mischen und Schmelzen von Ga₂O₃ als gelösten Stoff und PbO und PbF₂ als Lösungsmittel, dann das anschließende direkte Inkontaktbringen eines β-Ga₂O₃-Substrats mit der resultierenden Schmelze umfasst, um einen β-Ga₂O₃-Einkristall auf dem β-Ga₂O₃-Substrat durch ein Flüssigphasen-Epitaxieverfahren wachsen zu lassen, wodurch der β-Ga₂O₃ / β-Ga₂O₃-Mehrschichtkörper erhalten wird, in dem eine β-Ga₂ O₃ enthaltende Epitaxieschicht auf dem β-Ga₂ O₃ -Substrat aufgebracht ist.

4. Verfahren zur Herstellung eines β-Ga₂O₃ / β-Ga₂O₃-Mehrschichtkörpers gemäß Anspruch 3, wobei ein Mischungsverhältnis von Ga₂O₃ als gelöster Stoff und PbO und PbF₂ als Lösungsmittel von 2-20 Mol-% : 98-80 Mol-% und ein Mischungsverhältnis der Lösungsmittel PbO und PbF₂ = 2-80 Mol-% : 98-20 Mol% vorliegt.

5. Verfahren zur Herstellung eines β-Ga₂O₃ / β-Ga₂O₃-Mehrschichtkörpers gemäß einem der Ansprüche 1 bis 4, wobei die Schicht, die den durch das Flüssigphasen-Epitaxieverfahren gebildeten β-Ga₂O₃-Einkristall enthält, Fremdstoffe in einer Menge von 0,01 Mol-% oder mehr, jedoch 20 Mol-% oder weniger umfasst.

6. Verfahren zur Herstellung eines β-Ga₂O₃ / β-Ga₂O₃-Mehrschichtkörpers gemäß Anspruch 5, wobei das Fremdelement eines oder mehrere ausgewählt aus der Gruppe, bestehend aus Be, Mg, Ca, Sr, Ba, Ti, Zr, Hf, Fe, Co, Ni, Cu, Zn, Cd, Al, In, Si, Ge, Sn und Pb ist.

## Revendications

1. Méthode pour produire un corps multicouche ß-Ga₂O₃/ß-Ga₂O₃, la méthode comprenant mélanger et fondre Ga₂O₃ comme un soluté, et PbO et Bi₂O₃ comme des solvants, puis mettre un substrat ß-Ga₂O₃ en contact direct avec le fondu résultant, et permettre à un monocristal ß-Ga₂O₃ de croître sur le substrat ß-Ga₂O₃ par une méthode de croissance épitaxiale en phase liquide, obtenant ainsi le corps multicouche ß-Ga₂O₃/ß-Ga₂O₃ dans lequel une couche épitaxiale contenant ß-Ga₂O₃ est empilée sur le substrat ß-Ga₂O₃.

2. La méthode pour produire un corps multicouche ß-Ga₂O₃/ß-Ga₂O₃ selon la revendication 1, dans laquelle un ratio de mélange de Ga₂O₃ comme le soluté et de PbO et Bi₂O₃ comme des solvants est soluté : solvants = 5 - 30 mol % : 95 - 70 % et un ratio de mélange des solvants, PbO et Bi₂O₃, est PbO : Bi₂O₃ = 0,1 - 95 mol % : 99,9 - 5 mol %.

3. Méthode pour produire un corps multicouche ß-Ga₂O₃/ß-Ga₂O₃, comprenant mélanger et fondre Ga₂O₃ comme un soluté et PbO et PbF₂ comme des solvants, puis mettre un substrat ß-Ga₂O₃ en contact direct avec le fondu résultant, et permettre à un monocristal ß-Ga₂O₃ de croître sur le substrat ß-Ga₂O₃ par une méthode de croissance épitaxiale en phase liquide, obtenant ainsi le corps multicouche B-Ga₂O₃/ß-Ga₂O₃ dans lequel une couche épitaxiale contenant ß-Ga₂O₃ est empilée sur le substrat ß-Ga₂O₃.

4. La méthode pour produire un corps multicouche ß-Ga₂O₃/ß-Ga₂O₃ selon la revendication 3, dans laquelle un ratio de mélange de Ga₂O₃ comme un soluté et de PbO et PbF₂ comme des solvants est soluté : solvants = 2 - 20 mol % : 98 - 80 mol %, et un ratio de mélange des solvants, PbO et PF₂, est PbO : PF₂ = 2 - 80 mol % : 98 - 20 mol %.

5. La méthode pour produire un corps multicouche ß-Ga₂O₃/ß-Ga₂O₃ selon l'une quelconque des revendications 1 à 4, dans laquelle la couche contenant le monocristal B-Ga₂O₃ formé par la méthode de croissance épitaxiale en phase liquide comprend des éléments étrangers dans une quantité de 0,01 mol % ou plus mais de 20 mol % ou moins.

6. La méthode pour produire un corps multicouche ß-Ga₂O₃/ß-Ga₂O₃ selon la revendication 5, dans laquelle l'élément étranger est un ou plusieurs sélectionné parmi le groupe constitué de Be, Mg, Ca, Sr, Ba, Ti, Zr, Hf, Fe, Co, Ni, Cu, Zn, Cd, AI, In, Si, Ge, Sn et Pb.
